# EUROPEAN PATENT APPLICATION

(11) **EP 2 123 789 A1**
(43) Date of publication of application: **25.11.2009**
(21) Application number: 08156286.0
(22) Date of filing: 15.05.2008
(51) Int. Cl.: C23C 14/00

(54) **A method of producing hard coatings**

(71) Applicant: Eifeler Werkzeuge GmbH, 40595 Düsseldorf (DE)
(72) Inventor: Rogozin, Alexander, 40210 Düsseldorf (DE)
(74) Representative: Meyers, Hans-Wilhelm

(57) **Abstract**

A method of producing a hard coating on a substrate (5) by a combination of a physical vapor deposition and a plasma assisted chemical vapor deposition process, **characterized in that**
- a reactor (7) is provided with the substrate (5),
- a physical vapor deposition process is used for the decomposition of one or more targets (1-4),
- a gas comprising one or more components is introduced into the reactor wherein the one or more components contain compounds which are able to deposit an element or elements selected from the group consisting of Si, B, Y, Hf and V on the substrate,
- the gas is at least partially ionized in a cathodic arc or in the generated discharge of a magnetron sputtern device, and
- the substrate (5) is coated, wherein the coating comprises from about 2 at% to about 65 at% of said element or elements.

## Description

This invention pertains to a method of producing hard coatings, to a hard coating manufactured according to said method and the use of said method.

Molecules of transition metals, in particular the nitrides, borides, carbides or oxides of group IVB - VIB of the periodic system of the elements are well-known for their high hardness and wear resistance. Therefore, they, as well as their mixtures with aluminum, found widely use for wear-resistant coatings, e.g. TiN, TiB₂, CrCN, TiAlN, Al₂O₃.

Such coatings have been used for coating tools made of metals or cemented carbides, in particular cutting tools, because of the high oxidation resistance and high hardness of those materials. Further, the addition of elements like Y, Hf, V or Si causes a significant improvement of these types of hard coatings. Especially mixtures of metals (Me) with Si as a nitride, carbonitride or boride according to the formula ((Me)ₓSi₁₋ₓ)(CNB) have found wide application for wear-resistant coatings. It has been shown that addition of silicon to these mixtures in a certain range causes a remarkable increase in refinement of the crystalline structure of the coatings and an increase in hardness of the coating [S. Veprek, S. Reiprich and Li Shizhi, Appl. Phys. Lett. 66, 2640 (1995)] and as a consequence an increase in wear resistance [K. Yamamoto, S. Kujime, K. Takahara, Surface and Coatings Technology, Vol. 200, 5-6, (2005), 1383-1390]. Said Si-containing coatings have been produced by means of chemical vapor deposition (CVP), physical vapor deposition (PVD) or plasma-assisted chemical vapor deposition (PACVD) techniques so far. The well-known PVD technique for producing these coatings is based on the use of mixed target materials, e.g. TiₓSi₁₋ₓ, AlₓSi₁₋ₓ or Ti_{1-x-y} AlₓSi_{y}.

One object of the present invention is to provide a method of producing a hard coating on a substrate by a combined physical vapor deposition-plasma assisted chemical vapor deposition (PVD/PACVD) process that overcomes the restriction of the Si content in the produced hard coating given by the fixed amount of Si in the PVD targets which are used for the PVD process.

Figure 1 depicts schematically a reactor for use according to the invention.

Figure 2 shows a cathodic arc reactor.

Advantageously, hard coatings according to the present invention can be easily manufactured by directing a gas to the surface of a cathode. Another benefit of the process according to the present invention resides in that it allows the production of hard coatings on a substrate by a combined PVD and PACVD technique. More clearly a simple method is described to produce Si-containing coatings with varying Si-contents independent from the amount of Si of the used target material for the PVD process.

The present invention provides a method of producing a hard coating on a substrate 5 by a combination of a physical vapor deposition and a plasma assisted chemical vapor deposition process, **characterized in that**
- a reactor 7 is provided with the substrate 5,
- a PVD process is used for the decomposition of one or more targets 1-4
- a gas comprising one or more components is introduced into the reactor wherein the one or more components contain compounds which are able to deposit an element or elements selected from the group consisting of Si, B, Y, Hf and V on the substrate,
- the gas is at least partially ionized in a cathodic arc or in the generated discharge of a magnetron sputtern device, and
- the substrate is coated, wherein the coating comprises from about 2 at% to about 65 at% of said element or elements.

In particular, the substrate can further comprise a metal, e.g. Fe, Mn, W, V. Moreover, the reactor can be a reaction chamber, which is suitable for the method according to the present invention. Further, according to an embodiment of the present invention, a gas that is inflammable, is unlikely to ignite under the conditions of the method of producing a hard coating on a substrate, i. e. it fulfills the CGA P-23 (compressed gas association) standard for gas mixtures containing flammable and non-flammable components.

In another embodiment of the present invention, the gas is directed directly to the surface of the targets 1-4.

In one embodiment of the present invention a per se flammable or self-igniting gas, such as SiH₄, can be mixed with per se non-inflammable gases, such as nitrogen or argon, to obtain a gas comprising more components, which is not inflammable. Therefore, it is an advantage of the preset invention to use a less harmful or risky gas comprising more components than the pure compound or compounds of the components.

In particular a gaseous mixture of Si containing gas and nitrogen which is not flammable (see CGA P-23, Compressed Gas Association) is used for producing coatings with Si content >= 3 at% relative to the amount of metallic compounds in the coating.

In a further embodiment of the present invention, a gas comprises less than 10 at%, in particular less than 8, 6, 5, 4, 3, 2 or 1 at% of said element or elements.

In another embodiment of the present invention, it is possible to produce a hard coating comprising equal to or more than 3 at% Si by using a non inflammable mixture of < 1,4 % SiH₄ diluted in nitrogen during cathodic arc deposition.

In yet another embodiment of the present invention, it is possible to produce a hard coating comprising equal to or more than 10 at% Si by using a non-inflammable mixture of < 1,4 % SiH₄ diluted in nitrogen during the arc deposition by introducing this Si-containing gas mixture directly to the arc discharge of the cathode surface. By this measure, it is possible to obtain hard coatings comprising an increased content of Si vis-à-vis the coatings of the state of the art even at low gas flow rates.

The high ionization of the gas in the cathodic arc discharge leads to an ionization of the gas which allows even a non-inflammable compound like nitrogen and equal to or less than 1,4 at% of SiH₄ to form hard coatings with an amount of Si sufficient for a desired refinement of a crystalline structure and improved wear resistance of the produced coating, e.g. comprising 3 - 20 at% of Si.

Yet a further embodiment of the present invention is a method of producing a hard coating on a substrate, wherein said components are TiCl₄, CH₄, B₃N₃H₆, SiH₄ or B₂H₆.

In still another embodiment of the method according to the present invention, the hard coating comprises 3-65, 5-60, 5-50, 6-50, 8-45 ,3-30, 5-30, 10-30, 15-28, 15-26, 20-25, 21-23 or 23-30, or 25-30 at% of said element or elements. The amount of said element or elements can be easily varied during deposition by simply changing the flow rate of the gas as well by simply changing arc discharge currents. In this way, it is possible to produce nearly any kind of multilayer or gradient layer coating regarding the amount of said element or elements inside the coating.

This overcomes therefore the restriction of fixed mixtures of metals and elements, such as Si, in the targets of the widely used PVD processes which results in a therefore largely fixed composition of such mixtures of metals and elements, such as a coating comprising Si deposited on a substrate.

In yet another embodiment of the present invention, the component is SiH₄ and said element is Si.

Another embodiment of the present invention is a method, **characterized in that** the cathodic arc originates from a cathode comprising a transition metal of group IVB - VIB of the periodic table or a mixture thereof or Al or a mixture of Al and a mixture of said transition metals.

In one embodiment of the present invention the gas is directed to the surface of the cathode. In particular, the gas may be directed to the surface of the cathode.

By this set-up an enhanced activation and ionisation of the gas is obtained. Hence, by employing a gas comprising a low amount of said element or elements, a hard coating comprising an increased amount of the element or the elements can be obtained.

Subject matter of the present invention is a coating obtainable by the method according to the present invention.

In another embodiment of the present invention, the method of the invention is used for producing hard coatings on a substrate, in particular on steel or on cemented carbide. Further, the method according to the present invention can be used for producing hard coatings on a tool, in particular on a cutting tool.

In yet another embodiment of the present invention, a hard coating, for example of the type of (TiAlSi)N can be produced showing superior properties as far as coating smoothness and usage for cutting tools in comparison to a (TiAlSi)N type of coating with the same amount of Ti, Al, Si is concerned, which has been prepared by prior art cathodic arc processes. Therefore, it is a further advantage of the method according to the present invention to overcome the optionally increased roughness of (MeSi)CN-films produced by using mixed cathode materials including Si by prior art PVD techniques.

### Figures

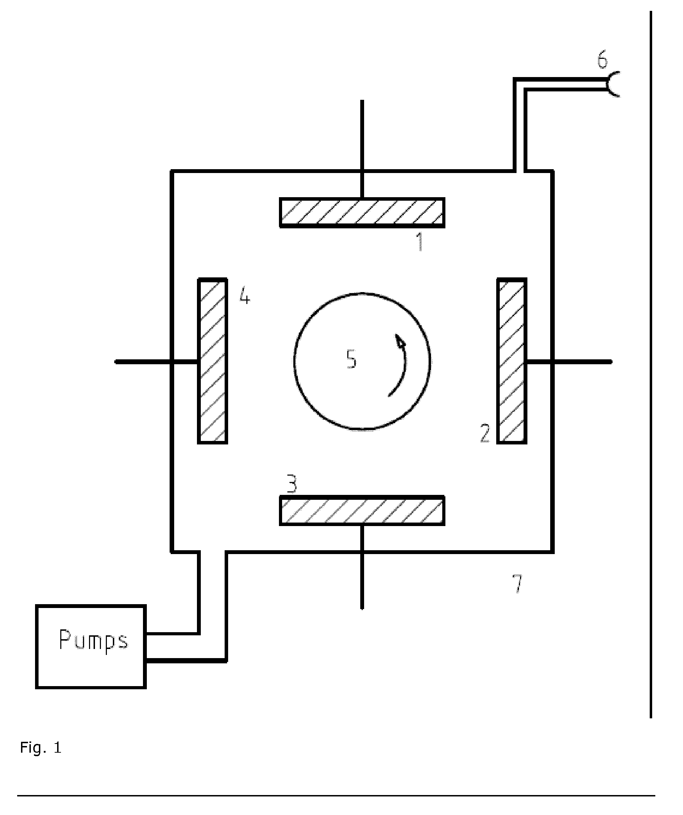

Figure 1 shows a cathodic arc reactor 7 comprising metallic targets 1-4 as cathode (e.g. AlTi, Ti, Al), a substrate 5 and a gas inlet 6. The substrate 5 can be rotated in order to obtain a homogenous coating.

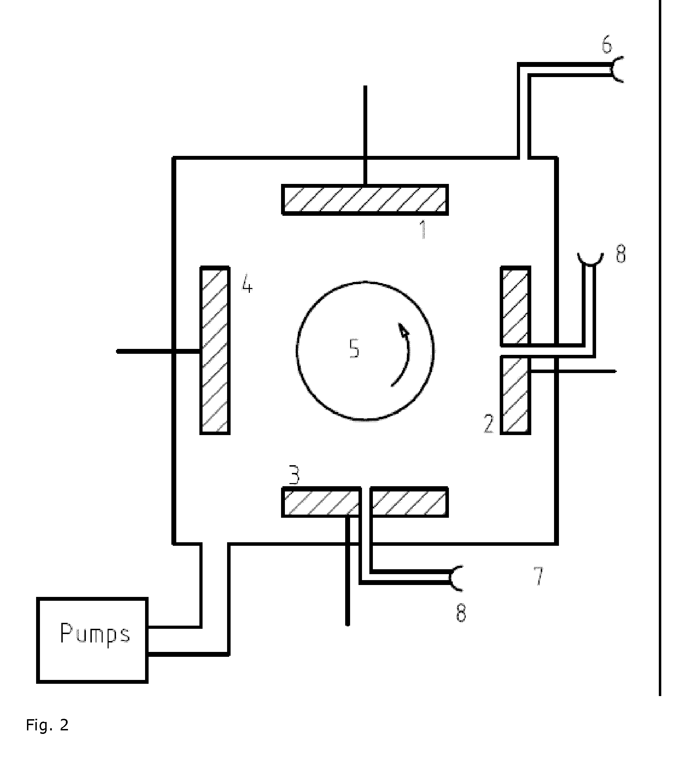

Figure 2 shows a cathodic arc reactor further comprising a gas inlet 8, whereby gases (e.g. SiH₄ and N₂) can be directed directly to the surface of e.g. two targets which represent the cathode. The substrate 5 can be rotateted in order to obtain a homogenous coating.

### Example 1

The following table (table 1) discloses the Si-content in coatings obtained by a cathodic arc arrangement (1 sccm = 0.0168875 mbar*l/s).

**Tab. 1: Si-content in coatings using a standard cathodic arc arrangement (see fig. 1)**

| Target material | Arc current [A] | Reactive gas | Gas flow of reactive gas into chamber [sccm] | Si content relative to metallic compound in AlTiSiN coating [at%] |
|---|---|---|---|---|
| AlTi (67/33) | 60 | (1.99 % SiH₄+N₂) | 430 | 6.0 |
| AlTi (67/33) | 90 | (1.99 % SiH₄+N₂) | 438 | 3.6 |
| AlTi (67/33) | 60 | (1.99 % SiH₄+N₂) | 276 | 3.1 |
| AlTi (67/33) | 60 | (1.3 % SiH₄+N₂) | 493 | 4.4 |
| AlTi (67/33) | 60 | (1.4% SiH₄+N₂) | 493 | 5.7 |

### Example 2

The following table discloses the Si-content of a hard coating obtained by direct introduction of a reactive gas to the surface of a target (see Fig. 2). In contrast to the coatings according to Example 1, the coatings comprise an significant increased amount of Si even at lower gas flow rates.

**Tab. 2: Si-content in hard coatings using a direct introduction of reactive gas to the surface of the cathode (see Fig. 2).**

| Target material | Arc current [A] | Reactive gas | Gas flow of reactive gas into chamber [sccm] | Si-content vs. metallic compound in AlTiSiN film [at%] |
|---|---|---|---|---|
| AlTi (67/33) | 40 | (1.99 % SiH₄+N₂) | 100 | 16.8 |
| AlTi (67/33) | 80 | (1.99 % SiH₄+N₂) | 100 | 12.5 |
| AlTi (67/33) | 40 | (1.99 % SiH₄+N₂) | 300 | 39.0 |
| AlTi (67/33) | 80 | (1.99 % SiH₄+N₂) | 300 | 29.9 |

## Claims

1. A method of producing a hard coating on a substrate (5) by a combination of a physical vapor deposition and a plasma assisted chemical vapor deposition process, **characterized in that**
- a reactor (7) is provided with the substrate (5),
- a physical vapor deposition process is used for the decomposition of one or more targets (1-4),
- a gas comprising one or more components is introduced into the reactor wherein the one or more components contain compounds which are able to deposit an element or elements selected from the group consisting of Si, B, Y, Hf and V on the substrate,
- the gas is at least partially ionized in a cathodic arc or in the generated discharge of a magnetron sputtern device, and
- the substrate (5) is coated, wherein the coating comprises from about 2 at% to about 65 at% of said element or elements.

2. The method according to claim 1, **characterized in that** the gas comprises less than or equal to 10 at%, in particular less than 8, 6, 5, 4, 3, 2 or 1 at% of said element or elements.

3. The method according to claim 1 and/or 2, **characterized in that** the gas is directed to the surface of the targets (1-4).

4. The method according to anyone of claims 1-3, **characterized in that** said compounds are TiCl₄, CH₄, B₃N₃H₆, SiH₄ or B₂H₆.

5. The method according to anyone of claims 1-4, **characterized in that** the coating comprises 3-65, 5-60, 8-50, 10-45, 3-40, 5-30, 10-30, 15-28, 20-25 or 25-30 at% of said element or elements.

6. The method according to anyone of claims 1-5, **characterized in that** said component is SiH₄,

7. The method according to claim 6, **characterized in that** said element is Si.

8. The method according to anyone of claims 1-7, **characterized in that** the cathodic arc originates from a cathode (1-4) comprising a transition metal out of group IVB - VIB of the periodic system of the elements or a mixture thereof or Al or a mixture of Al and a mixture of those transition metals.

9. The method according to anyone of claims 1-8, **characterized in that** the gas is not inflammable.

10. A coating, **characterized in that** it is obtainable by the method of claim 1.

11. Use of the method according to claim 1 for producing hard coatings on a substrate, in particular on a metal.

12. Use according to claim 11 for producing hard coatings on a tool, in particular on a cutting tool.
